(19) Europäisches Patentamt
European Patent Office
Office européen des brevets

(11) **EP 1 468 445 B1**

(12) **EUROPEAN PATENT SPECIFICATION**

(45) Date of publication and mention
of the grant of the patent:
**09.08.2006 Bulletin 2006/32**

(51) Int Cl.:
*H01L 21/18* (2006.01)    *H01L 21/265* (2006.01)
*H01L 21/762* (2006.01)   *H01L 21/20* (2006.01)
*H01L 21/76* (2006.01)

(21) Application number: **03701540.1**

(22) Date of filing: **21.01.2003**

(86) International application number:
**PCT/EP2003/000692**

(87) International publication number:
**WO 2003/063213 (31.07.2003 Gazette 2003/31)**

(54) **OPTIMIZED METHOD OF TRANSFER OF A THIN LAYER OF SILICON CARBIDE TO A RECEIVING SUBSTRATE**

OPTIMIERTES VERFAHREN ZUM TRANSFERIEREN EINER SILIZIUMKARBID-DÜNNSCHICHT AUF EINEM EMPFANGSUBSTRAT

PROCEDE OPTIMISE POUR TRANSFERER UNE COUCHE MINCE DE CARBURE DE SILICIUM SUR UN SUBSTRAT DE RECEPTION

(84) Designated Contracting States:
**AT BE BG CH CY CZ DE DK EE ES FI FR GB GR HU IE IT LI LU MC NL PT SE SI SK TR**

(30) Priority: **23.01.2002 FR 0200813**

(43) Date of publication of application:
**20.10.2004 Bulletin 2004/43**

(73) Proprietor: **S.O.I.Tec Silicon on Insulator Technologies**
**38190 Bernin (FR)**

(72) Inventors:
  • **GHYSELEN, Bruno**
    **F-38170 Seyssinet-Pariset (FR)**
  • **LETERTRE, Fabrice**
    **F-38000 Grenoble (FR)**

(74) Representative: **Bomer, Françoise Marie**
    **Cabinet Régimbeau**
    **Espace Performance**
    **Bâtiment K**
    **35769 Saint-Gregoire-Cedex (FR)**

(56) References cited:
**US-A- 6 150 239        US-B1- 6 355 541**

• **DI CIOCCIO L ET AL: "Silicon carbide on insulator formation by the Smart-Cut(R) process" MATERIALS SCIENCE AND ENGINEERING B, ELSEVIER SEQUOIA, LAUSANNE, CH, vol. 46, no. 1-3, 1 April 1997 (1997-04-01), pages 349-356, XP004085343 ISSN: 0921-5107**
• **DI CIOCCIO L ET AL: "Silicon carbide on insulator formation using the Smart Cut process " ELECTRONICS LETTERS, IEE STEVENAGE, GB, vol. 32, no. 12, 6 June 1996 (1996-06-06), pages 1144-1145, XP006005228 ISSN: 0013-5194**
• **BENNETT J A ET AL: "COMPLETE SURFACE EXFOLIATION OF 4H-SIC BY H+- AND SI+- COIMPLANTATION" APPLIED PHYSICS LETTERS, AMERICAN INSTITUTE OF PHYSICS. NEW YORK, US, vol. 76, no. 22, 29 May 2000 (2000-05-29), pages 3265-3267, XP000954315 ISSN: 0003-6951 cited in the application**
• **GREGORY R B ET AL: "THE EFFECTS OF DAMAGE ON HYDROGEN-IMPLANT-INDUCED THIN-FILM SEPARATION FROM BULK SILICON CARBIDE" MATERIALS RESEARCH SOCIETY SYMPOSIUM PROCEEDINGS, MATERIALS RESEARCH SOCIETY, PITTSBURG, PA, US, vol. 572, 5 April 1999 (1999-04-05), pages 33-38, XP001040858 ISSN: 0272-9172 cited in the application**

EP 1 468 445 B1

- **TONG Q-Y ET AL: "Si and SiC layer transfer by high temperature hydrogen implantation and lower temperature layer splitting" ELECTRONICS LETTERS, IEE STEVENAGE, GB, vol. 34, no. 4, 19 February 1998 (1998-02-19), pages 407-408, XP006009324 ISSN: 0013-5194**

## Description

The present invention relates to an optimized method of transfer of a thin layer of monocrystalline silicon carbide (SiC) derived from a source substrate of this same material to a receiving or stiffening substrate, this method particularly permitting recycling of the said substrate after the transfer of this thin layer.

The method known under the trademark "Smart Cut" enables a thin layer to be transferred from a source substrate to a receiving substrate of the type of oxidized silicon or polycrystalline silicon carbide, for example. This method likewise enables the source substrate from which the thin layer has been taken to be reused.

However, after each layer transfer operation, the upper surface of the source substrate has a certain number of surface irregularities.

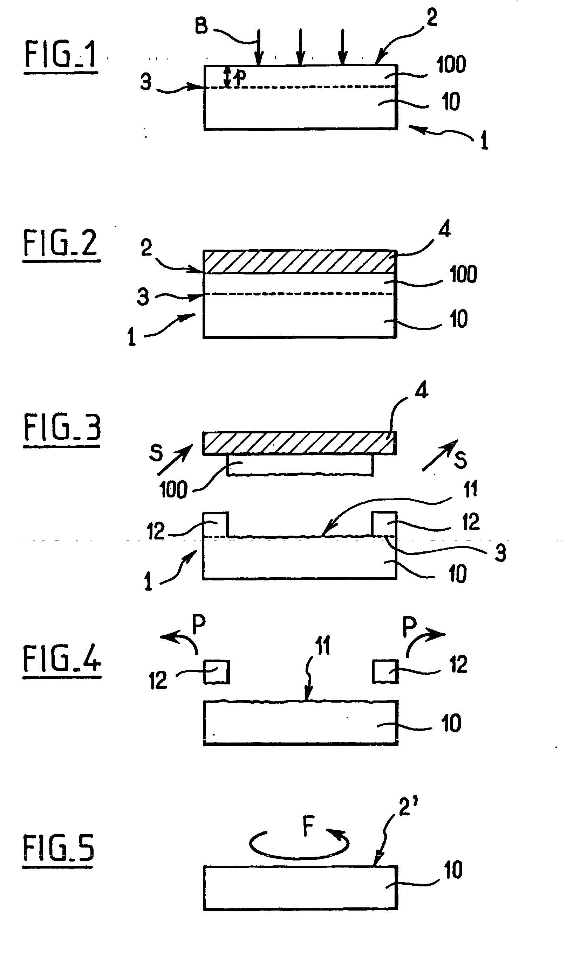

The formation of these surface irregularities will be described with reference to the accompanying Figures 1-5, which show a specific example of implementation of the "Smart Cut" method. This method is known to those skilled in the art and will not be described in detail.

Figure 1 shows a source substrate 1 which has a planar face 2, termed "front face", on which a step of implantation of gas species has been performed. This implantation is carried out by ion bombardment, for example with $H^+$ ions (reference B on Figure 1) using an implanter.

This implantation is performed at a specific energy, implantation dose, and temperature, so as to create an embrittlement zone, referenced 3, in the neighborhood of the mean implantation depth p of the ions.

This embrittlement zone 3 delimits two portions in the said source substrate 1, i.e., on the one hand, an upper thin layer 100 extending between the front face 2 and the said embrittlement zone 3, and on the other hand, the remainder of the substrate, referenced 10.

As shown in Figure 2, a stiffener or receiving substrate 4 is then applied to the front face 2 of the source substrate 1.

This stiffener is chosen by those skilled in the art as a function of the final application envisaged. In a known manner, it can be applied, for example, by evaporation, spraying, chemical vapor deposition, or can be bonded using an adhesive or by a technique of "bonding by molecular adhesion" known in English terminology as "wafer bonding".

As shown in Figure 3, a step is then carried out of detachment of the thin layer 100 from the remainder 10 of the substrate 1. This detachment step, symbolized by the arrows S, is performed either by application of mechanical stresses to the stiffener 4, or by the application of thermal energy to the assembly of stiffener 4 and substrate 1.

The wafers constituting the source substrate 1 used for molecular adhesion possess subsided edges due to chamfering operations performed, for example, during their manufacture. As a result, the adhesion forces between the stiffener 4 and the front face 2 are weaker in the region of the substantially annular periphery of the said source substrate 1.

Consequently, during the stripping of this stiffener 4, only the central portion of the thin layer 100, strongly adhering to the stiffener 4, is detached, while the substantially annular periphery of this thin layer 100 remains integral with the remainder 10 of the source substrate 1.

This source substrate 1 thus simultaneously presents, in its central portion, a surface roughness 11 due to the rupture in the region of the embrittlement zone 3, and at its periphery, an excess thickness 12 or surface topology in the form of a blistered zone corresponding to zones not transferred to the receiving substrate or stiffener 4.

The depth of this zone of excess thickness 12 is equal to the thickness of the transferred thin layer 100. It typically varies from several tens of nanometers to more than a micrometer. This depth is determined by the implantation energy of the hydrogen ions.

In the Figures, the zone 12 of excess thickness has been intentionally shown, for the sake of simplification and schematization, with a cross section with right angles and with a marked thickness with respect to the remainder 10 of the source substrate. In reality, it has a much more irregular shape and a proportionally smaller thickness.

Before proceeding to the transfer of the following thin layer, it is imperative to recycle the remainder 10 of the source substrate.

This recycling consists, on the one hand, of a step of planarization of the surface (arrows P), that is, of elimination of the excess thickness 12 and of the subsided zones, and on the other hand, of a specific finishing step (arrow F) permitting elimination of the surface roughness 11 to attain a substrate having a new front face 2'.

These recycling steps are generally performed by mechanical and/or mechano-chemical polishing techniques.

In the specific case where the source substrate 1 is silicon carbide, an extremely hard material, these polishing steps are found to be extremely long and costly.

The prior art document, "The effects of damage on hydrogen-implant-induced thin-film separation from bulk silicon carbide", R.B. Gregory, Material Research Society Symp., Vol. 572, 1999, shows that the choice of the conditions of hydrogen implantation into the silicon carbide permits varying the percentage of the zone exfoliated, that is, the percentage of the free surface of silicon carbide which is spontaneously eliminated during the thermal annealing of the substrate.

In this article, the curve of results showing the H+ ion implantation dose as a function of the percentage of the zone exfoliated possesses a bell shape at an implantation energy of 60 keV, with a maximum value of 33% of the exfoliated zone, for an implantation dose of $5.5 \cdot 10^{16}$ $H^+/cm^2$. On departing from this value, that is, on increasing or decreasing the implantation dose, this exfoliation percentage decreases.

The document "Complete surface exfoliation of 4H-SiC by $H^+$ and Si+ co-implantation", J.A. Bennett, Applied Physics Letters, Vol. 76, No. 22, pp. 3265-3267, May 29, 2000, shows that it is possible to perform a complete exfoliation of the surface of a silicon carbide substrate by a co-implantation of $H^+$ and $Si^+$ ions.

More specifically, this document describes trials performed on 4H-SiC silicon carbide by implanting Si+ ions at various doses and at an energy of 190 keV, then $H^+$ ions at an implantation dose of $6 \cdot 10^{16}$ $H^+/cm^2$ and at an energy of 60 keV. Implantation doses of Si+ greater than or equal to $5 \cdot 10^5$ $Si^+/cm^2$ permitted exfoliation of 100% of the silicon carbide surface.

However, the Si ion implantation dose necessary for the total exfoliation of the SiC layer is also high enough to render the silicon carbide amorphous. This method is therefore incompatible with the transfer of a thin film of silicon carbide of good crystalline quality, since it is unimaginable to recover this thin film for the later formation of devices used in microelectronics or opto-electronics.

The object of the invention is to remedy the said disadvantages and particularly to optimize the implantation conditions to facilitate the recycling of a silicon carbide source substrate.

This object is attained by means of a method of transfer of a thin layer of monocrystalline silicon carbide, derived from a source substrate of the same material, to a receiving substrate, this method being intended to facilitate the recycling of the remainder of this source substrate, comprising the steps consisting of:

- bombarding a planar face, termed "front face", of the said source substrate with a majority of $H^+$ ions to form an embrittlement zone at a depth near the mean implantation depth p of the said ions, this zone forming a delimitation between the said thin layer and the remainder of the said substrate, the bombardment with the $H^+$ ions being performed with an implantation energy E and an implantation dose D.
- bonding the said receiving substrate to the said front face,
- detaching the said thin layer from the remainder of the source substrate, along the said embrittlement zone.

According to the characteristics of the invention, the implantation of the $H^+$ ions is performed in accordance with the following inequality, in which the implantation dose D is expressed in a number of $H^+$ ions per cm2 and the implantation energy E, expressed in keV, is greater than or equal to 95 keV:

$$[(E \times 1 \cdot 10^{14} + 5 \cdot 10^{16})/1.1] \leq D \leq [(E \times 1 \cdot 10^{14} + 5 \cdot 10^{16})/0.9]$$

so as to embrittle the said embrittlement zone in an optimized manner, and after this step of bonding, during or after the detaching steps a thermal budget is applied sufficient to completely or almost completely exfoliate the annular peripheral zone of the said thin layer of the source substrate which has not been transferred to the said receiving substrate.

According to other advantageous but non-limiting characteristics of the invention, taken alone or in combination:

- the implanted ions are exclusively $H^+$ ions;
- the implantation of $H^+$ ions is performed without intentional heating of the source substrate during the exposure to the ion beam;
- the source substrate is of disoriented monocrystalline silicon carbide, for example of SiC-4H type;
- the detachment is first performed along the said optimized embrittlement zone by the application of external mechanical stresses, and the sufficient thermal budget is then applied for completely or almost completely exfoliating the annular peripheral zone of the thin layer which has not been transferred to the receiving substrate, or else:

- the detachment along the optimized embrittlement zone and the complete - or almost complete - exfoliation of the annular peripheral zone of the thin layer which has not been transferred to the receiving substrate are performed simultaneously by the application of the appropriate thermal budget;
- the application of the thermal budget necessary for completely or almost completely exfoliating the said zone of the said thin layer zone takes place above 700°C;
- the ion bombardment is effected in a random fashion;
- the source substrate is covered with a layer of amorphous material of a thickness less than or equal to about 50 nanometers (50 nm), before the step of ion bombardment;
- the bonding of the receiving substrate to the front face of the source substrate is performed by molecular adhesion;
- at least one of the faces, among the front face and the contact face of the receiving substrate, is covered with an intermediate bonding layer;
- the said layer of amorphous material and/or the said intermediate bonding layer are formed of a material chosen from among silicon oxide ($SiO_2$) or silicon nitride ($Si_3N_4$) ;
- the receiving substrate is chosen from among silicon, silicon carbide, gallium nitride, aluminum nitride, sapphire, indium phosphide, gallium arsenide, or germanium;
- the receiving substrate is silicon obtained by zone fusion growth, with a low oxygen content;
- the method furthermore comprises a step of finishing the front face of the source substrate obtained after detachment;

The invention will now be described with reference to an embodiment of the invention, given as a purely illustrative example, this description being based on the accompanying drawings, in which:

- figures 1-5 are diagrams showing the different steps of a method of transfer of a thin silicon carbide layer according to the state of the art,
- figures 6-18 are diagrams showing the different steps of the method according to the invention and its alternatives,
- figure 19 is a graph showing the exfoliated zone percentage as a function of the $H^+$ ion implantation dose D, at various implantation energies, and
- figure 20 is a graph showing the values of $H^+$ ion implantation energy E as a function of the $H^+$ ion implantation dose D to obtain a 100% exfoliation of the implanted layer.

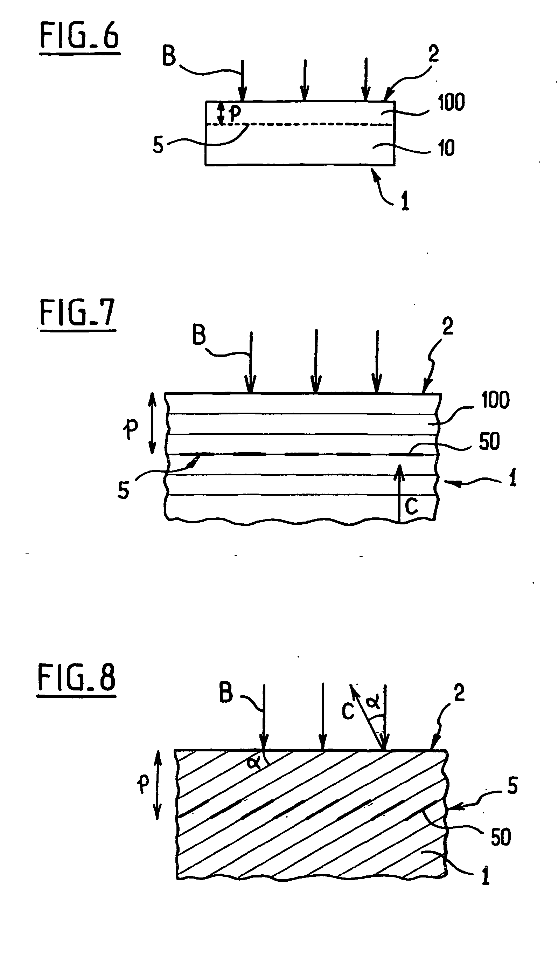

The method according to the invention will now be described with reference to Figures 6-18.

Figures 6-18 are closely similar to Figures 1-5, and identical elements bear the same reference numerals.

It can be seen in Fig. 6 that the object of the invention is to optimize the implantation conditions B of atomic species within a source substrate 1 of monocrystalline silicon carbide, so as to create in the neighborhood of the means depth p of ion implantation, a zone 5, termed "optimized embrittlement zone", to later be able to exfoliate, after the detachment of the layer 100 and after having applied an appropriate thermal budget, 100% or about 100% of the blistered excess thickness zone 12 which remained integral with the remainder 10 of the substrate in the prior art method (see Figure 3).

The term "optimized embrittlement" means that atomic species are introduced into the crystal in a precise and controlled manner in order to activate in an optimum manner the embrittlement mechanisms which are used.

Within the scope of the invention, the implantation of atomic species consists of an ion bombardment of the front face 2 of the substrate 1 with $H^+$ ions, and possibly joint bombardment with H+ ions and helium or boron ions, the $H^+$ ions nevertheless remaining in the majority.

The implantation of these ions in the surface of the monocrystalline silicon carbide source substrate 1 is performed using an ion beam implanter.

Various trials of implantation in the surface of a silicon carbide source substrate 1 were performed in order to determine the best operating conditions.

As illustrated in the accompanying Figures 7 and 8, which show the crystalline structure of silicon carbide, the implantation B of ions is always performed perpendicularly to the planar surface 2 of the source substrate 1.

In the case illustrated in Figure 7, corresponding to an oriented silicon carbide crystal (known to those skilled in the art by the English term "on axis"), the stackings of silicon and carbon atoms are situated in a plane parallel to the upper planar surface or front face 2. The ions then penetrate parallel to the crystal growth axis C of the said crystal.

On the contrary, in the case illustrated in Figure 8, corresponding to a disoriented silicon carbide crystal (known to those skilled in the art by the English term "off axis"), the stackings of silicon and carbon atoms are situated in a plane which is not parallel to the front face 2 but which forms an angle $\alpha$ with the latter. The ions then penetrate along an axis perpendicular to the said front face 2 but angularly offset from the said crystal growth axis C by the value of this angle $\alpha$.

The disorientation of the crystal is obtained in an artificial fashion, generally by cutting the crystal. The angle $\alpha$ can have different values. It is 3.5°, 8°, or 15° in currently commercially available crystals of silicon carbide.

In the two said cases, the microcavities 50 resulting from ion implantation are mainly formed in a plane perpendicular to the crystalline growth axis C.

Consequently, in the oriented crystal, the microcavities 50 are parallel to the front face 2 and form an optimized embrittlement zone 5 parallel to the plane of the said front face 2 and occurring as a practically continuous fracture line, while in a disoriented crystal, these microcavities 50 are inclined with respect to the plane of the front face 2 and do not form a continuous line.

It has been observed experimentally that for a given implantation dose D and energy E, a greater embrittlement of the zone 5, and later a better exfoliation percentage of the excess thickness zone 12, is obtained when the implantation is performed on a disoriented crystal.

In an advantageous manner, in the method of the invention, this ion implantation is performed in a random fashion, to avoid the phenomenon termed "channeling".

The channeling phenomenon occurs when ions are implanted along specific channels or crystallographic axes. The ions thus introduced encounter fewer atoms on their trajectories, resulting in fewer interactions and less braking of the said ions. These ions will therefore be implanted more deeply.

In the process according to the invention, it is on the contrary sought to avoid this channeling phenomenon for industrial reasons, because channeled implantation is not an industrially feasible technique.

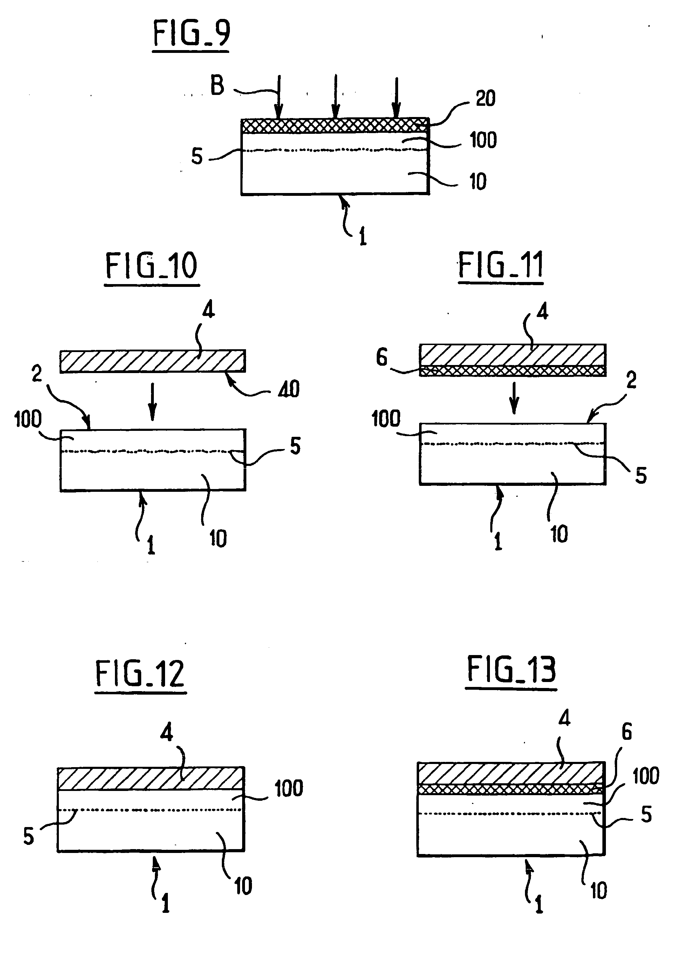

Furthermore, in order to improve the percentage of exfoliation finally obtained during detachment, and to operate in a random implantation mode, it is preferable (but not obligatory) to perform ion implantation through a layer of amorphous material 20 formed on the front face 2 of the substrate 1. This alternative embodiment is shown in Figure 9.

This layer of amorphous material 20 is advantageously a layer of silicon oxide ($SiO_2$) or of silicon nitride ($Si_3N_4$). However, it should not exceed a thickness of about 50 nm ($5 \cdot 10^{-9}$ m), at the risk of modifying the relationship connecting the implantation energy E and the implanted dose D as will be defined later.

Finally, the trials performed showed that this ion implantation should preferably be preformed without external heat supply, that is, at a maximum temperature of about 200°C, the implantation being able to bring the silicon carbide substrate substantially to this temperature.

If the substrate is heated during implantation, for example to temperatures markedly greater than 650°C, degradation or suppression of the macroscopic exfoliation phenomenon is observed. This can be explained by the activation during implantation of diffusion and recrystallization mechanisms which participate in the process. This activation in situ, which is not controlled, degrades the control of the desired exfoliation effect.

Other, complementary trials were performed in order to determine the best pairs of implantation dose D and implantation energy E to be used. These trials will later be described in detail.

The receiving substrate 4 is then bonded to the front face 2 of the source substrate 1.

The bonding of this substrate 4 is advantageously effected by molecular adhesion, since this is the mode of bonding best suited to electronic applications, particularly due to the homogeneity of the bonding forces used and to the possibility of bonding together numerous materials of different natures. However, it could likewise be performed by other known prior art techniques.

The bonding can be performed by applying one of the faces 40, termed "contact face", of the receiving substrate 4 to the front face 2 of the source substrate 1, either directly (see Figure 10) or by means of one or more intermediate bonding layers 6 deposited on the contact face 40 of the substrate 4 (as shown in Figure 11), or on the front face 2 of the source substrate 1, or on these two faces.

These intermediate bonding layers 6 are insulating layers, for example, of silicon oxide ($SiO_2$) or silicon nitride ($Si_3N_4$), or on the other hand, conductive layers.

It will be noted that when the implantation B is performed through a layer of amorphous material 20, the latter can then play the part of intermediate bonding layer 6.

The assembly of layers respectively illustrated in Figures 12 and 13 is obtained.

The receiving substrate is advantageously (but not obligatory) chosen from silicon, silicon carbide, gallium nitride (GaN), aluminum nitride (AlN), sapphire, indium phosphide (InP), gallium arsenide (GaAs), or germanium (Ge). Other materials can likewise be used.

This receiving substrate can likewise be a fragile substrate, such as silicon obtained by zone fusion growth, with a low oxygen content, that is, monocrystalline silicon obtained by the zone fusion method starting from polycrystalline silicon.

Detachment (arrows S) of the receiving substrate 4 and of the thin layer 100 from the remainder 10 of the source substrate 1 is then performed.

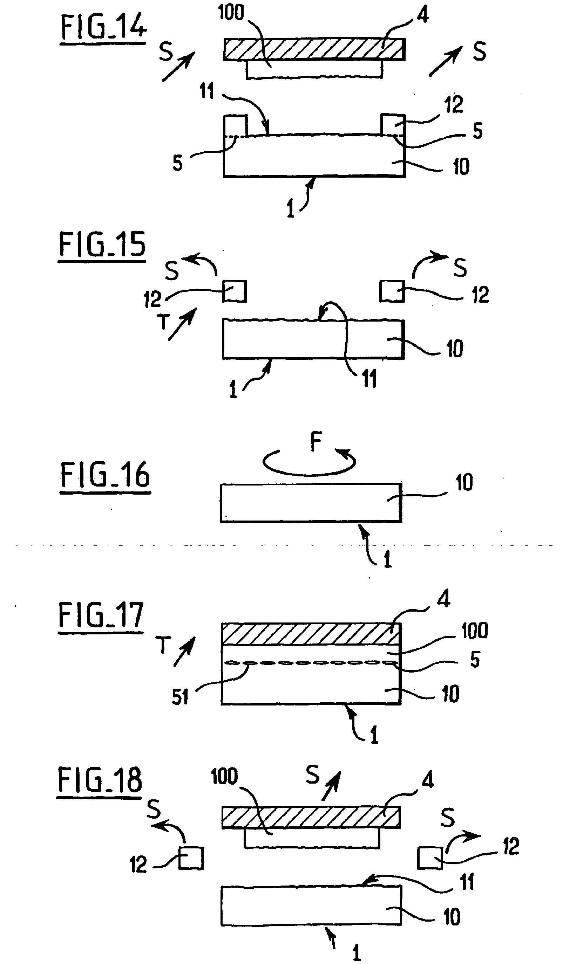

This detachment S can be performed either by application of external mechanical stresses (as shown in Figure 14), or by a thermal treatment with an appropriate thermal budget (see Figure 17).

In a fashion known to those skilled in the art, these external mechanical stresses can be, for example, the application of shear, traction, or compression forces, or the application of ultrasound, or of an electrostatic or electromagnetic field.

If the detachment S is performed using external mechanical stresses, an annealing treatment then follows, according to an appropriate thermal budget to completely, or almost completely, exfoliate the zone 12 of the thin layer 100 from the source substrate 1 which has not been bonded to the receiving substrate 4 (see Figure 15). The thermal budget corresponds to the product of the annealing treatment temperature by the duration of this treatment.

This treatment is nevertheless simpler and quicker to use than the polishing used in the state of the art for proceeding to such an operation.

There then only remains a possible finishing step F of the source substrate 1 (see Figure 16).

This finishing step aims at eliminating the surface roughness 11. It is generally performed by a mechano-chemical polishing.

A step of finishing the free surface of the thin layer 100 can likewise be performed.

If the detachment S of the thin layer 100 from the remainder 10 of the source substrate 1 is performed by a thermal annealing treatment (see Figure 17), the complete or almost complete exfoliation of the zone 12 is then simultaneously produced (see Figure 18). In practice, this application of heat causes the defects or microcavities 50 to grow until they form micro-cracks 51 which, connected together, result in a cleavage plane and in rupture along the said optimized embrittlement zone 5.

The possible finishing step F is then performed, as illustrated in Figure 16.

The trials to determine the best pairs of values of implantation dose D and implantation energy E of H$^+$ ions will now be described.

Operating conditions:

H$^+$ ion implantation was performed on the front face of a monocrystalline silicon carbide SiC4H substrate disoriented by 8° (known to those skilled in the art as "SiC4H 8° off-axis"), covered with an amorphous layer of silicon oxide about 50 nanometers (50 nm) thick.

The implantation temperature was below 200°C.

Four series of trials were performed with implantation energies E of respectively 50 keV, 95 keV, 140 keV and 180 keV.

For each value of energy E, the implantation dose D was varied between $5.25 \cdot 10^{16}$ H$^+$/cm$^2$ and $8 \cdot 10^{16}$ H$^+$/cm$^2$.

A receiving substrate 4 constituted by silicon was then applied to the source substrate 1, and annealing was then performed at 900°C for 1 hour.

The percentage of exfoliation of the peripheral zone 12, which in the prior art remained integral with the remainder 10 of the substrate, was then measured.

The results obtained are given in the following Table.

A value of 100% means that the whole of the zone 12 which is not in intimate contact (that is, has not adhered) with the receiving substrate 4 is exfoliated. A value of 30%, for example, means that only 30% of the excess thickness zone 12 is exfoliated, and that 70% of this zone 12 remains integral with the remainder 10 of the substrate 1.

| | | Implantation dose D ($10^{16}$ H$^+$/cm$^2$) | | | | | | | | | |
|---|---|---|---|---|---|---|---|---|---|---|---|
| | Implantation Energy E (keV) | 5.25 | 5.5 | 5.75 | 6 | 6.5 | 6.75 | 7 | 7.25 | 7.5 | 8 |
| Exfoliated Zone (%) | 50 | 5 | 50 | 15 | | | | | | | |
| | 95 | | 10 | | 100 | 60 | | 30 | | | |
| | 140 | | | | 40 | 80 | 100 | 60 | | 40 | |
| | 180 | | | | | 30 | | 90 | 100 | 80 | 40 |

Trials carried out with implantation energies less than 50 keV did not give good results for exfoliation.

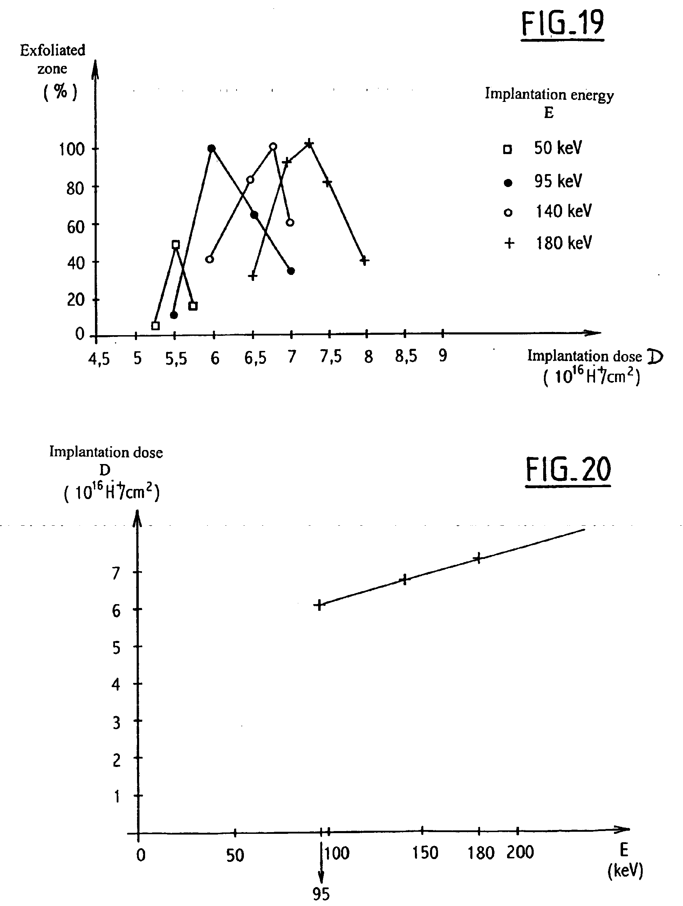

The results obtained have been transferred to the graph of Figure 19. It can be seen that for each implantation energy E value greater than or equal to 95 keV, there is an implantation dose value D which enables 100% of exfoliation to be obtained (bell-shaped curves obtained).

Figure 20 is a graph showing the H+ ion implantation dose D as a function of the implantation energy E of these same ions to obtain 100% of exfoliated zone.

The straight line obtained corresponds to the following equation:

$$D = E \times 1 \cdot 10^{14} + 5 \cdot 10^{16} \qquad (1)$$

with E ≥ 95 keV,

in which the H$^+$ ion implantation energy E is expressed in keV and the implantation dose D of these ions is expressed in H$^+$ ions/cm$^2$.

Taking account of the fluctuations of the values of D and E connected to possible slight experimental variations and to the tolerances of manufacture and control of the implantation apparatus used, it is considered that the pairs of values of D and E should obey the following inequality:

$$-\epsilon \times D \leq D - (E \times 1\cdot10^{14} + 5\cdot10^{16}) \leq \epsilon \times D \qquad (2)$$

where D and E have the aforementioned meanings and where $\epsilon \times D$ represents the absolute tolerance for a given value of E between the theoretical value of D obtained according to the above Equation (1) and an acceptable value of D, and where e represents the relative tolerance.

After experimentation, it was considered that this relative tolerance $\epsilon$ was equal to 10%.

The following inequality (3) results from this:

$$- 0.1 \times D \leq D - (E \times 1\cdot10^{14} + 5\cdot10^{16}) \leq 0.1 \times D$$

which can also be expressed as the following inequality (4):

$$[(E\times1\cdot10^{14}+5\cdot10^{16})/1.1] \leq D \leq [(E\times1\cdot10^{14} + 5\cdot10^{16})/(0.9)]$$

The pairs of values of D and E which obey the above inequality (4) permit an optimized embrittlement of the embrittlement zone 5 to be obtained, and after having applied a sufficient thermal budget, permits complete or almost complete exfoliation of the zone 12 of the thin layer 100 which has not been transferred to the receiving substrate 4.

Supplementary trials were then performed to determine the appropriate thermal budget.

Below 700°C, the mechanisms of diffusion of hydrogen within the SiC are practically inoperative.

It was thus possible to determine that the thermal budget necessary for complete or almost complete exfoliation of the zone 12 has to be above 700°C and preferably above 800°C.

There was thus obtained, on the one hand, a thin layer 100 of SiC, of good crystalline quality, and on the other hand, a source substrate 1, the front face of which is free from surface topologies 12.

**Claims**

1.  Method of transfer of a thin layer (100) of monocrystalline silicon carbide, derived from a source substrate (1) of the same material, to a receiving substrate (4), this method, intended to facilitate the recycling of the remainder (10) of this source substrate (1), comprising the steps consisting of:

    - bombarding a planar face (2), termed "front face", of the said source substrate (1) with a majority of $H^+$ ions to form an embrittlement zone (5) at a depth near the mean implantation depth p of the said ions, this zone (5) forming a delimitation between the said thin layer (100) and the remainder (10) of the said substrate (1), the bombardment with the $H^+$ ions being performed with an implantation energy E and an implantation dose D.
    - bonding the said receiving substrate (4) to the said front face (2),
    - detaching the said thin layer (100) from the remainder (10) of the said source substrate (1), along the said embrittlement zone (5),

    **characterized in that** the implantation of $H^+$ ions is performed according to the following inequality, in which the implantation dose D is expressed in number of $H^+$ ions/cm$^2$ and the implantation energy E, expressed in keV, is greater than or equal to 95 keV:

$$[(E\times1\cdot10^{14} + 5\cdot10^{16})/1.1] \leq D \leq [(E\times1\cdot10^{14} + 5\cdot10^{16})/0.9]$$

    so as to embrittle the said embrittlement zone (5) in an optimized fashion, and **in that** after the step of bonding, during or after the detaching step a thermal budget is applied sufficient to completely or almost completely exfoliate the annular peripheral zone (12) of the thin layer (100) of the source substrate (1) which has not been transferred to the said receiving substrate (4).

**2.** Method according to claim 1, **characterized in that** the implanted ions are exclusively $H^+$ ions.

**3.** Method according to claim 1 or 2, **characterized in that** the implantation of $H^+$ ions is performed without intentional heating of the source substrate (1) during the exposure to the ion beam.

**4.** Method according to any one of the foregoing claims, **characterized in that** the source substrate (1) is disoriented monocrystalline silicon carbide.

**5.** Method according to claim 4, **characterized in that** the source substrate (1) to disoriented monocrystalline silicon carbide of SiC-4H type.

**6.** Method according to any one of the foregoing claims, **characterized in that** detachment is first performed along the said optimized embrittlement zone (5) by the application of external mechanical stresses and **in that** the sufficient thermal budget is then applied for completely or almost completely exfoliating said annular peripheral zone (12) of the thin layer (100) which has not been transferred to the receiving substrate(4).

**7.** Method according to any one of claims 1-5, **characterized in that** the detachment along the optimized embrittlement zone (5) and the complete - or almost complete - exfoliation of said annular peripheral zone (12) of the thin layer (100) are simultaneously performed by the application of the appropriate thermal budget.

**8.** Method according to any one of the foregoing claims, **characterized in that** the application of the thermal budget necessary for completely or almost completely exfoliating the said zone (12) from the thin layer (100) is effected above 700°C.

**9.** Method according to any one of the foregoing claims, **characterized in that** the ion bombardment is performed in a random fashion.

**10.** Method according to any one of the foregoing claims, **characterized in that** the source substrate (1) is covered with a layer of amorphous material (20) of thickness less than or equal to about 50 nanometers, before the step of ion bombardment.

**11.** Method according to any one of the foregoing claims, **characterized in that** the bonding of the receiving substrate (4) to the front face (2) of the source substrate (1) is performed by molecular adhesion.

**12.** Method according to claim 11, **characterized in that** at least one of the faces between the front face (2) and the contact face (40) of the receiving substrate (4) is covered with an intermediate bonding layer (6).

**13.** Method according to claim 10 or 12, **characterized in that** the said layer of amorphous material (20) and/or the said intermediate bonding layer (6) are formed of a material chosen from among silicon oxide ($SiO_2$) or silicon nitride ($Si_3N_4$).

**14.** Method according to any one of the foregoing claims, **characterized in that** the receiving substrate (4) is chosen from among silicon, silicon carbide, gallium nitride, aluminum nitride, sapphire, indium phosphide, gallium arsenide, or germanium.

**15.** Method according to any one of the foregoing claims, **characterized in that** the receiving substrate (4) is silicon obtained by zone melting growth, with a low oxygen content.

**16.** Method according to any one of the foregoing claims, **characterized in that** it furthermore comprises a finishing step F of the front face (11) of the remainder (10) of the source substrate (1) obtained after detachment.

**Patentansprüche**

**1.** Verfahren zum Übertragen einer dünnen Schicht (100) von monokristallinem Siliziumcarbid, welche von einem Quellensubstrat (1) desselben Materials gewonnen wird, auf ein Empfängersubstrat (4), wobei das Verfahren, welches das Recycling des Restes (10) diesen Quellensubstrats (11) erleichtern möchte, die Schritte umfaßt:

- Beschießen einer ebenen Fläche (2), genannt "Vorderseite", des Quellensubstrats (1) mit einer Mehrheit von H$^+$ Ionen, um eine Versprödungszone (5) in einer Tiefe in Nähe der mittleren Implantationstiefe p der Ionen zu bilden, wobei diese Zone (5) eine Grenze zwischen der dünnen Schicht (100) und dem Rest (10) des Substrats (1) bildet, und wobei der Beschuß mit den H$^+$ Ionen mit einer Implantationsenergie E und einer Implantationsdosis D durchgeführt wird,
- Verbinden des Empfängersubstrats (4) an die Vorderseite (2);
- Abtrennen der dünnen Schicht (100) von dem Rest (10) des Quellensubstrats (1) entlang der Versprödungszone (5),

**dadurch gekennzeichnet, daß** die Implantation von H$^+$ Ionen entsprechend der folgenden Ungleichung durchgeführt wird, in welcher die Implantationsdosis D in einer Anzahl von H$^+$ Ionen/cm$^2$ angegeben wird und die Implantationsenergie E, angegeben in keV, größer oder gleich 95 keV ist:

$$[(Ex1 \cdot 10^{14} + 5 \cdot 10^{16})/1.1] \leq D \leq [(Ex1 \cdot 10^{14} + 5 \cdot 10^{16})/0.9]$$

derart, daß die Versprödungszone (5) in optimaler Weise versprödet und derart, daß nach dem Schritt des Verbindens, während oder nach dem Abtrennungsschritt, eine thermische Last angelegt wird, die ausreichend ist, um die ringförmige nicht auf dem Empfängersubstrat (4) übertragene Umfangszone (12) der dünnen Schicht (100) von dem Quellensubstrat (1) vollständig oder fast vollständig abzulösen.

2. Verfahren nach Anspruch 1, **dadurch gekennzeichnet, daß** die implantierten Ionen ausschließlich H$^+$ Ionen sind.

3. Verfahren nach Anspruch 1 oder 2, **dadurch gekennzeichnet, daß** die Implantation von H$^+$ Ionen ohne absichtliche Erwärmung des Quellensubstrats (1) durchgeführt wird, während dieses dem Ionenstrahl ausgesetzt ist.

4. Verfahren nach einem der vorstehenden Ansprüche, **dadurch gekennzeichnet, daß** das Quellensubstrat (1) ein fehlausgerichtetes monokristallines Siliziumcarbid ist.

5. Verfahren nach Ansprüche 4, **dadurch gekennzeichnet, daß** das Quellensubstrat (1) ein SiC-4H fehlausgerichtetes monokristallines Siliziumcarbid ist.

6. Verfahren nach einem der vorstehenden Ansprüche, **dadurch gekennzeichnet, daß** die Trennung zuerst entlang der optimierten Versprödungsszone (5) durch das Anlegen von externen mechanischen Belastungen durchgeführt wird, und sodann die ausreichende thermische Last angelegt wird, um die ringförmige nicht auf dem Empfängersubstrat (4) übertragene Umfangszone (12) der dünnen Schicht (100) vollständig oder fast vollständig abzulösen.

7. Verfahren nach einem der Ansprüche 1 bis 5, **dadurch gekennzeichnet, daß** die Trennung entlang der optimierten Versprödungszone (5) und die vollständige - oder fast vollständige - Ablösung der ringförmigen nicht auf dem Empfängersubstrat (4) übertragene Umfangszone (12) der dünnen Schicht (100) durch Anlegen der geeigneten thermischen Last gleichzeitig durchgeführt werden.

8. Verfahren nach einem der vorstehenden Ansprüche, **dadurch gekennzeichnet, daß** das Anlegen der thermischen Last, die notwendig ist, um die Zone (12) von der dünnen Schicht (100) vollständig oder fast vollständig abzulösen, bei oberhalb 700°C durchgeführt wird.

9. Verfahren nach einem der vorstehenden Ansprüche, **dadurch gekennzeichnet, daß** der Ionenbeschuß in einer zufälligen Art und Weise durchgeführt wird.

10. Verfahren nach einem der vorstehenden Ansprüche, **dadurch gekennzeichnet, daß** das Quellensubstrat (1) mit einer Schicht von einem amorphen Material (20) von einer Dicke von weniger als oder gleich etwa 50 Nanometer abgedeckt wird, bevor der Schritt des Ionenbeschusses durchgeführt wird.

11. Verfahren nach einem der vorstehenden Ansprüche, **dadurch gekennzeichnet, daß** die Verbindung des Empfängersubstrats (4) an die Vorderseite (2) des Quellensubstrats (1) durch molekulare Haftung durchgeführt wird.

12. Verfahren nach Anspruch 11, **dadurch gekennzeichnet, daß** wenigstens eine der Seiten von der Vorderseite (2) und der Kontaktseite (40) des Empfängersubstrats (4) mit einer Zwischenverbindungsschicht (6) bedeckt ist.

13. Verfahren nach Anspruch 10 oder 12, **dadurch gekennzeichnet, daß** die Schicht von amorphen Material (20) und/oder die Zwischenverbindungsschicht (6) aus einem Material ausgewählt aus Siliziumoxid ($SiO_2$) oder Siliziumnitrid ($Si_3N_4$) gebildet wird/werden.

14. Verfahren nach einem der vorstehenden Ansprüche, **dadurch gekennzeichnet, daß** das Empfängersubstrat (4) aus Silizium, Siliziumcarbid, Galliumnitrid, Aluminiumnitrid, Sapphir, Indiumphosphid, Galliumarsenid oder Germanium ausgewählt wird.

15. Verfahren nach einem der vorstehenden Ansprüche, **dadurch gekennzeichnet, daß** das Empfängersubstrat (4) Silizium ist, welches durch Zonenschmelzwachstum, mit einem geringen Sauerstoffanteil, erhalten wird.

16. Verfahren nach einem der vorstehenden Ansprüche, **dadurch gekennzeichnet, daß** es ferner einen Endbehandlungsschritt F der Vorderseite (11) des Restes (10) des Quellensubstrats (1), welches nach der Abtrennung erhalten wird, umfaßt.


**Revendications**

1. Procédé de report d'une couche mince (100) de carbure de silicium monocristallin, issue d'un substrat source (1) de ce même matériau, sur un substrat d'accueil (4), ce procédé destiné à faciliter le recyclage du reste (10) de ce substrat source (1) comprenant les étapes consistant à :

   - bombarder de façon majoritaire avec des ions H⁺, une face plane (2) dite "face avant" dudit substrat source (1), pour former à une profondeur voisine de la profondeur moyenne p d'implantation desdits ions, une zone de fragilisation (5), cette zone (5) formant une délimitation entre ladite couche mince (100) et le reste (10) dudit substrat (1), le bombardement avec les ions H⁺ étant effectué selon une énergie d'implantant E et une dose d'implantation D,
   - coller ledit substrat d'accueil (4) sur ladite face avant (2),
   - détacher ladite couche mince (100) du reste (10) dudit substrat source (1), le long de ladite zone de fragilisation (5),

   **caractérisé en ce que** l'implantation des ions H⁺ est effectuée en respectant l'inéquation suivante, dans laquelle la dose d'implantation D est exprimée en nombre d'ions $H^+/cm^2$ et l'énergie d'implantation E exprimée en keV est supérieure ou égale à 95 keV :

$$[(\mathbf{E} \times 1.10^{14} + 5.10^{16}) / 1,1] \leq \mathbf{D} \leq [(\mathbf{E} \times 1.10^{14} + 5.10^{16}) / 0,9]$$

   de façon à fragiliser de façon optimisée ladite zone de fragilisation (5) et **en ce que** l'on apporte après l'étape de collage, durant ou après l'étape de détachement, un budget thermique suffisant pour exfolier complètement ou quasiment complètement la zone annulaire périphérique (12) de ladite couche mince (100) du substrat source (1) qui n'a pas été reportée sur ledit substrat d'accueil (4).

2. Procédé selon la revendication 1, **caractérisé en ce que** les ions implantés sont uniquement des ions H⁺.

3. Procédé selon la revendication 1 ou 2, **caractérisé en ce que** l'implantation des ions H⁺ est effectuée sans chauffage volontaire du substrat source (1) durant l'exposition au faisceau d'ions.

4. Procédé selon l'une quelconque des revendications précédentes, **caractérisé en ce que** le substrat source (1) est en carbure de silicium monocristallin désorienté.

5. Procédé selon la revendication 4, **caractérisé en ce que** le substrat source (1) est en carbure de silicium monocristallin désorienté de type SiC-4H.

6. Procédé selon l'une quelconque des revendications précédentes, **caractérisé en ce qu'**on réalise d'abord le détachement le long de ladite zone de fragilisation optimisée (5) par apport de contraintes mécaniques extérieures et **en ce qu'**on apporte ensuite le budget thermique suffisant pour exfolier complètement ou quasiment complètement la zone périphérique annulaire (12) de la couche mince (100) qui n'a pas été reportée sur le substrat d'accueil (4).

7. Procédé selon l'une quelconque des revendications 1 à 5,
**caractérisé en ce que** l'on réalise simultanément le détachement le long de la zone de fragilisation optimisée (5) et l'exfoliation complète - ou quasi complète - de la zone (12) de la couche mince (100) qui n'a pas été reportée sur le substrat d'accueil (4), par l'apport du budget thermique approprié.

8. Procédé selon l'une quelconque des revendications précédentes, **caractérisé en ce que** l'apport du budget thermique nécessaire pour exfolier complètement ou quasi complètement ladite zone (12) de la couche mince (100) se fait au-dessus de 700°C.

9. Procédé selon l'une quelconque des revendications précédentes, **caractérisé en ce que** le bombardement ionique est effectué de façon aléatoire.

10. Procédé selon l'une quelconque des revendications précédentes, **caractérisé en ce que** le substrat source (1) est recouvert d'une couche de matériau amorphe (20) d'une épaisseur inférieure ou égale à environ 50 nanomètres, avant l'étape de bombardement ionique.

11. Procédé selon l'une quelconque des revendications précédentes, **caractérisé en ce que** le collage du substrat d'accueil (4) sur la face avant (2) du substrat source (1) est réalisé par adhésion moléculaire.

12. Procédé selon la revendication 11, **caractérisé en ce qu'**au moins l'une des faces entre la face avant (2) et la face de contact (40) du substrat d'accueil (4) est recouverte d'une couche intermédiaire de collage (6).

13. Procédé selon la revendication 10 ou 12, **caractérisé en ce que** ladite couche de matériau amorphe (20) et/ou ladite couche intermédiaire de collage (6) sont constituées d'un matériau choisi parmi l'oxyde de silicium (SiO$_2$) ou le nitrure de silicium (Si$_3$N$_4$).

14. Procédé selon l'une quelconque des revendications précédentes, **caractérisé en ce que** le substrat d'accueil (4) est choisi parmi le silicium, le carbure de silicium, le nitrure de gallium, le nitrure d'aluminium, le saphir, le phosphure d'indium, l'arséniure de gallium ou le germanium.

15. Procédé selon l'une quelconque des revendications précédentes, **caractérisé en ce que** le substrat d'accueil (4) est du silicium obtenu par croissance par fusion de zone, à faible teneur en oxygène.

16. Procédé selon l'une quelconque des revendications précédentes, **caractérisé en ce qu'**il comprend en outre une étape de finition F de la face avant (11) du reste (10) du substrat source (1) obtenu après le détachement.

FIG.1

FIG.2

FIG.3

FIG.4

FIG.5

## FIG.6

## FIG.7

## FIG.8

## FIG_9

## FIG_10

## FIG_11

## FIG_12

## FIG_13

FIG.14

FIG.15

FIG.16

FIG.17

FIG.18

## FIG_19

Exfoliated
zone
( % )

Implantation energy
E

□   50 keV

●   95 keV

o   140 keV

+   180 keV

Implantation dose $D$
( $10^{16} H^+/cm^2$ )

## FIG_20

Implantation dose
D
( $10^{16} H^+/cm^2$ )

E
(keV)

95

17